Europäisches Patentamt

European Patent Office

Office européen des brevets

(11) Veröffentlichungsnummer : **0 075 968**
**B1**

(12) # EUROPÄISCHE PATENTSCHRIFT

(45) Veröffentlichungstag der Patentschrift :
18.09.85

(21) Anmeldenummer : 82200955.1

(22) Anmeldetag : 26.07.82

(51) Int. Cl.⁴ : **H 03 K   3/57, F 42 C  11/06**

(54) **Steuerschaltung zum Zünden einer niederohmigen Zündpille.**

(30) Priorität : 24.09.81 CH 6153/81

(43) Veröffentlichungstag der Anmeldung :
06.04.83 Patentblatt 83/14

(45) Bekanntmachung des Hinweises auf die Patenterteilung : 18.09.85 Patentblatt 85/38

(84) Benannte Vertragsstaaten :
**BE CH DE FR GB IT LI NL SE**

(56) Entgegenhaltungen :
**EP-A- 0 008 835**
**DE-B- 1 955 025**
**US-A- 3 638 035**
**US-A- 3 788 226**

(73) Patentinhaber : **Werkzeugmaschinenfabrik Oerli-**
**kon-Bührle AG**
**Birchstrasse 155**
**CH-8050 Zürich (CH)**

(72) Erfinder : **Münzel, Klaus, Dipl.-Ing. ETH**
**Flüehstrasse 32**
**CH-5313 Klingnau (CH)**

Jouve, 18, rue St-Denis, 75001 Paris, France

# 0 075 968

**Beschreibung**

Die Erfindung betrifft eine Steuerschaltung zum Zünden einer niederohmigen Zündpille über einen Leistungsschalter, mit einer Spannungsquelle.

Eine bekannte Steuerschaltung dieser Art ist in der deutschen Schrift DE-B-2 750 972 beschrieben. Diese Schaltung dient zum Ansteuern von niederohmigen Lasten über einen mit einer Stromquelle verbundenen Leistungsschalter, insbesondere zum Ansteuern niederohmiger Zündpillen in Zündschaltungen.

Wird eine solche Schaltung in einem Geschoss verwendet bei dem als Stromquelle ein Speisekondensator vorhanden ist, der erst beim Abschuss des Geschosses durch einen Stromgenerator aufgeladen wird, dann sind besondere Schutzmassnahmen erforderlich, nämlich :

a) Es muss verhindert werden, dass beim Aufladen des Speisekondensators die Zündpille gezündet wird bevor eine Mindestspannung erreicht ist.

b) Bei Ausfall des Speisekondensators besteht die Gefahr, dass durch eine grosse Spannungsanstiegsgeschwindigkeit ein vorzeitiges Zünden der Zündpille erfolgt, insbesondere falls unerwünschte Störsignale vorhanden sind.

Bei der erwähnten bekannten Steuerschaltung fehlen Schutzvorrichtungen, welche ein vorzeitiges Zünden der Zündpille in den genannten beiden Fällen verhindern.

Eine weitere bekannte Steuerschaltung dieser Art ist in der europäischen Patentanmeldung EP-A1-008 835 beschrieben. Bei dieser Schaltung werden durch einen Generator zwei in Serie geschaltete Kondensatoren aufgeladen. Die Spannung des zweiten Kondensators ist durch einen Zenereffekt begrenzt, der zwischen Basis und Kathode eines Thyristors entsteht. Der Thyristor wird nach einer bestimmten Zeit nach dem Aufladen des ersten Kondensators leitend, wodurch die Vorrohrsicherheit gewährleistet ist. Bei Aufschlag wird ein Schalter geschlossen, der die Zündung gewährleistet.

Nachteilig an dieser bekannten Steuerschaltung ist, dass auch in ihrem normalen Betrieb immer zwei Kondensatoren aufgeladen werden müssen. Bei kleinkalibrigen Geschossen, bei denen der Generator nur wenig Energie liefert, führt das zu einem unzulässig grossen Energiebedarf.

Der erfindungsgemässen Steuerschaltung liegt die Aufgabe zugrunde, ein vorzeitiges Zünden der Zündpille beim Aufladen des Speisekondensators zu vermeiden, auch bei Verwendung eines kleinen Generators und bei Ausfall des Speisekondensators ein vorzeitiges Zünden der Zündpille durch grosse Spannungsanstiegsgeschwindigkeiten und unerwünschte Störsignale zu verhindern.

Diese Aufgabe wird erfindungsgemäss dadurch gelöst, dass

a) ein von der Spannungsquelle (U) aufladbarer Zündkondensator (C1) angeordnet ist, der mit dem Leistungsschalter (T6a, T6b) und mit der Zündpille (Z) verbunden ist,

b) eine statische Sperrschaltung (B) angeordnet ist, welche ein Zünden der Zündpille (Z) verhindert, solange der Zündkondensator (C1) aufgeladen wird, mit einem Transistor (T4) der die Basis des Leistungsschalters (T6b) mit Masse verbindet,

c) eine statische Entriegelungsschaltung (A) angeordnet ist, welche die Sperrung aufhebt, sobald der Zündkondensator (C1) aufgeladen ist, mit einer Zenerdiode (D1) zum Ausschalten der Sperrschaltung (B) sobald die Spannung des Zündkondensators (C1) den Schaltwert der Zenerdiode (D1) erreicht hat,

d) eine dynamische Sperrschaltung (C) angeordnet ist, welche bei Ausfall des Zündkondensators (C1) ein unbeabsichtigtes Zünden der Zündpille (Z) während des beabsichtigten Ladens des Zündkondensators (C1) verhindert, mit einem Kondensator (C2), der bei steilem Anstieg der Zündspannung eine gewisse Sperrzeit gewährleistet.

Ein besonderer Vorteil dieser Schaltung besteht darin, dass nur Bipolartechnologie verwendet wird. Eine Integration der Schaltung ist daher leicht möglich. Ein weiterer Vorteil besteht darin, dass sich durch die Ueberwachung der Kondensatorspannung eine äusserst störsichere Steuerschaltung aufbauen lässt. Ausserdem ist der Platzbedarf dieser Steuerschaltung relativ klein, wodurch der Einbau in ein Geschoss erleichtert wird. Ferner besitzt die Steuerschaltung eine geringe Verlustleistung im Ruhezustand. Ein Ausführungsbeispiel der erfindungsgemässen Steuervorrichtung ist im folgenden anhand der beigefügten Zeichnung ausführlich beschrieben. Es zeigt :

Figur 1 ein Schaltschema der Steuervorrichtung, wobei die zusammengehörigen Teile durch strichpunktierte Linien voneinander abgegrenzt sind.

Figur 2 ein Diagramm über den Spannungsverlauf bei Aufladen des Speisekondensators.

Figur 3 ein Diagramm über den Spannungsverlauf beim Entladen des Speisekondensators.

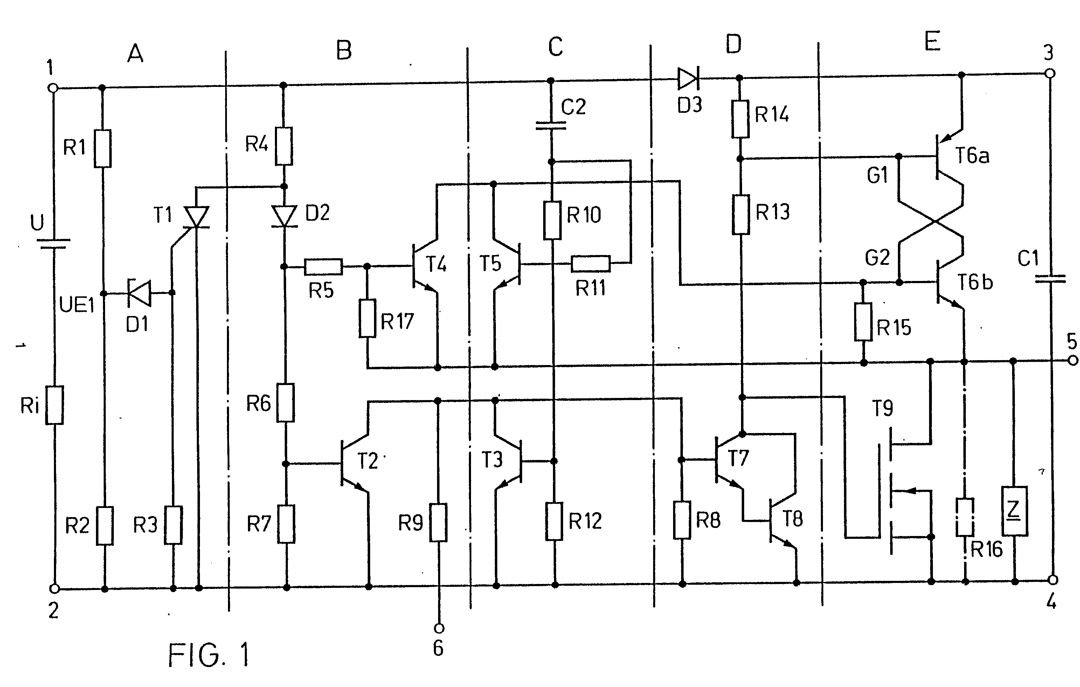

Gemäss Fig. 1 setzt sich die Steuerschaltung aus folgenden Teilschaltungen zusammen :

A. Entriegelungsschaltung,
B. Statische Sperrschaltung,
C. Dynamische Sperrschaltung,
D. Darlington Schaltung und
E. Zündpillenschaltung.

Die Zündpillenschaltung E

Gemäss Fig. 1 besitzt die Steuerschaltung zum Zünden eines Detonators oder einer niederohmigen

2

# 0 075 968

Zündpille Z einen Kondensator C1 der einerseits über die Klemmen 3 und 1 und andererseits über Klemmen 4 und 2 an eine Spannungsquelle U angeschlossen ist. Die Zündpille Z ist einerseits über zwei Transistoren T6b und T6a an die Klemmen 3 und 1 und andererseits an die Klemmen 4 und 2 angeschlossen. Die Steuerung der beiden Transistoren T6b und T6a erfolgt von den Knotenpunkten G1 und G2. Die Zündpille Z ist ferner über die Klemmen 4 und 5 und über einen ohmschen Widerstand R16 oder einen C-MOS-Schalter T9 kurzgeschlossen.

### Die Darlington Schaltung D

Zur Steuerung der Transistoren T6b und T6a dient eine Darlington Schaltung, welche durch zwei Transistoren T7 und T8 gebildet wird. Der Eingang des Transistors T8 ist über zwei ohmsche Widerstände R13 und R14 an die Klemmen 3 und 1 angeschlossen und der Ausgang des Transistors T8 ist direkt an die Klemmen 4 und 2 angeschlossen. Die Basis des Transistors T8 ist an den Ausgang des Transistors T7 angeschlossen und der Eingang des Transistors T7 ist ebenfalls über die beiden ohmschen Widerstände R13 und R14 an die Klemmen 3 und 1 angeschlossen. An die Basis des Transistors T7 ist ein Steuereingang 6 über einen ohmschen Widerstand R9 angeschlossen. Der Ausgang des Transistors T8 ist über einen Widerstand R8 mit der Basis des Transistors T7 verbunden.

### Die statische Sperrschaltung B

Damit der Kondensator C1 zuverlässig aufgeladen werden kann, ohne dass während des Ladens die Zündpille Z gezündet wird, ist eine statische Sperrschaltung B vorhanden. Diese statische Sperrschaltung besteht aus zwei Transistoren T4 und T2 und den fünf ohmschen Widerständen R4, R5, R6, R7 und R17. Der Transistor T4 verbindet den Ausgang des Transistors T6b mit dessen Basis und der Transistor T2 verbindet den Ausgang der obenerwähnten Darlington Schaltung mit deren Basis, d.h. den Ausgang des Transistors T8 mit der Basis des Transistors T7. Die Basis des Transistors T4 ist einerseits über die ohmschen Widerstände R5 und R4 an die Klemmen 3 und 1 angeschlossen und andererseits über den ohmschen Widerstand R17 an den Ausgang des Transistors T6b. Die Basis des Transistors T2 ist einerseits über die ohmschen Widerstände R6, R4 an die Klemmen 3 und 1 angeschlossen und andererseits über den ohmschen Widerstand R7 an die Klemmen 4 und 2.

### Die dynamische Sperrschaltung C

Falls der Kondensator C1 defekt ist, kann ein plötzlicher Spannungsanstieg ein ungewolltes Zünden der Zündpille Z bewirken. Um dieses unbeabsichtigte Zünden zu vermeiden, ist eine dynamische Sperrschaltung C angeordnet. Diese dynamische Sperrschaltung C besteht aus zwei Transistoren T3 und T5, den drei ohmschen Widerständen R10, R11 und R12 und einem Kondensator C2. Der erste Transistor T3 verbindet, genau wie der Transistor T2, den Ausgang der Darlington Schaltung mit deren Basis, d.h. den Ausgang des Transistors T8 mit der Basis des Transistors T7. Der zweite Transistor T5 verbindet, genau wie der Transistor T4, den Ausgang des Transistors T6b mit dessen Basis. Die Basis des Transistors T3 ist einerseits über den ohmschen Widerstand R10 und den Kondensator C2 an die Klemmen 3 und 1 angeschlossen und andererseits über den ohmschen Widerstand R12 an die Klemmen 4 und 2. Die Basis des Transistors T5 ist einerseits über den ohmschen Widerstand R11 und den Kondensator C2 an die Klemmen 3 und 1 angeschlossen und andererseits über die ohmschen Widerstände R11, R10 und R12 an die Klemmen 4 und 2.

### Die statische Entriegelungsschaltung A

Nach dem Aufladen des Kondensators C1 kann die statische Sperrschaltung B aufgehoben werden ; zu diesem Zweck ist eine statische Entriegelungsschaltung A angeordnet. Diese Entriegelungsschaltung A angeordnet. Diese Entriegelungsschaltung A besteht aus einem Thyristor T1, einer Zenerdiode D1 und drei ohmschen Widerständen R1, R2 und R3. Die beiden ohmschen Widerstände R1 und R2 verbinden die Klemmen 1 und 2 miteinander und bilden einen Spannungsteiler. Zwischen den Widerständen R1 und R2 entsteht daher die Spannung UE1. An diese Spannung UE1 ist über die Zenerdiode D1 der Thyristor T1 angeschlossen. Der Thyristor T1 verbindet den ohmschen Widerstand R4, der an die Klemme 1 angeschlossen ist, mit der Klemme 2. Die Zenerdiode D1 ist ferner über einen Widerstand R3 mit der Klemme 2 verbunden.

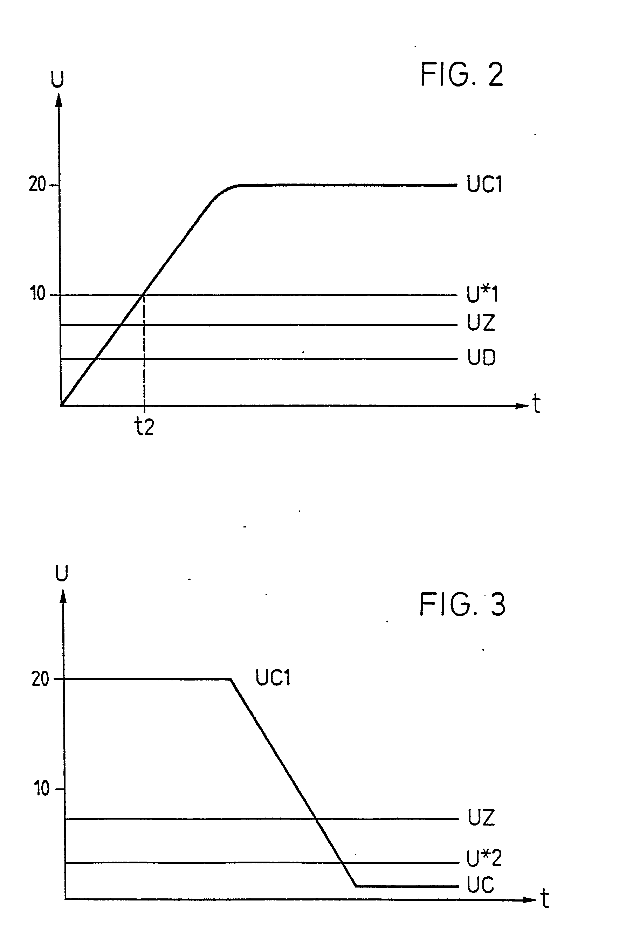

Die Wirkungsweise der beschriebenen Steuerschaltung ist wie folgt. Sobald die Steuerschaltung an die Spannungsquelle U angeschlossen wird, bildet sich an der Klemme 1 die Eingangsspannung U und zwischen den ohmschen Widerständen R1 und R2 die Eingangsspannung UE1. Der Kondensator C1 beginnt sich aufzuladen und an der Klemme 3 bildet sich die Spannung UC1 (Fig. 2).

Während des Ladevorganges ist die statische Sperrschaltung B wirksam, denn über die Widerstände R4 und R5 gelangt Spannung an die Basis des Transistors T4, wodurch dieser leitend wird. Ebenso gelangt über die Widerstände R4 und R6 Spannung an die Basis des Transistors T2, wodurch dieser ebenfalls leitend wird. Solange der Transistor T4 leitend ist, bleiben die Transistoren T6a und T6b gesperrt und solange der Transistor T2 leitend ist, bleibt die Darlington Stufe und somit auch der Steuereingang 6 gesperrt. Gemäss Fig. 2 wächst die Kondensatorspannung UC1 in der Zeit auf den Wert U*1 an. Dabei wächst auch die Spannung UE1.

Sobald die Spannung UE1 den Schaltwert der Zenerdiode D1 übersteigt, wird die Zenerdiode D1 leitend und es gelangt Spannung an den Gate Eingang des Thyristors T1, wodurch dieser ebenfalls leitend wird. Dadurch verschwindet die Spannung U*1 an der Basis der Transistoren T4 und T2, wodurch diese nicht mehr leitend sind. Somit ist die Wirkung der statischen Sperrschaltung B aufgehoben.

Falls durch den Steuereingang 6 eine Spannung an die Basis der Darlington Schaltung D angelegt wird, wird diese Schaltung leitend und es entsteht eine Spannung an der Basis des Transistors T6a, wodurch dieser leitend wird und eine Spannung an der Basis des Transistors T6b entsteht. Somit wird auch T6b leitend und die Zündpille Z kann gezündet werden.

Beim Zünden der Zündpille Z sinkt die Spannung im Kondensator C1 gemäss Fig. 3. Sobald die Kondensator Spannung UC1 auf die Sperrspannung U*2 absinkt, erfolgt eine aktive Sperrung der Transistoren T6a und T6b. Der Wert der Sperrspannung U*2 ist bei der Entladung des Kondensators C1 wesentlich kleiner als der Wert der Sperrspannung U*1 beim Laden des Kondensators C1, da der Thyristor T1 erst bei einem sehr kleinen Wert der Kondensatorspannung UC1 ausschaltet.

In Fig. 2 und 3 sind die minimale Zündspannung UZ der Zündpille Z eingezeichnet und die zum Steuern der Darlington Schaltung D erforderliche Spannung UD. Falls durch eine Störung der Kondensator C1 ausfällt, dann steigt die Spannung nicht, wie in Fig. 2 dargestellt, in der Zeit t2 an, sondern wesentlich schneller. Falls bei diesem Spannungsanstieg eine Störspannung am Steuereingang 6 vorhanden ist, dann kann die Spannungsanstiegsgeschwindigkeit so gross sein, dass die statische Sperrschaltung B nicht wirksam ist. Für diesen Fall ist die dynamische Sperrschaltung C vorgesehen. Durch den erwähnten Spannungsanstieg wird der zweite Kondensator C2 aufgeladen, wodurch einerseits über den Widerstand R10 an die Basis des Transistors T3 Spannung gelegt wird und andererseits über den Widerstand R11 Spannung an die Basis des Transistors T5 gelegt wird. Die Transistoren T3 und T5 werden leitend und bewirken, analog wie die Transistoren T2 und T4, dass einerseits die Darlington Schaltung D und andererseits die Transistoren T6a und T6b gesperrt bleiben.

Die Diode D3 verhindert, dass sich der Zündkondensator C1 in die Batterie U oder in einen nicht dargestellten Stromgenerator entladen kann. Somit kann sich der Zündkondensator C1 nur durch eventuelle Leckströme der Diode D3 oder des Transistors T6a und T6b oder den Transistoren T7 und T8 der Darlington Schaltung D entladen. D.h. die Verlustleistung der beschriebenen Schaltung ist klein. Statt dem ohmschen Widerstand R16 kann ein C MOS Transistor 9 angeordnet sein, der beim Zünden der Zündpille Z fliesst. Beim ohmschen Widerstand R16 lässt sich hingegen nicht vermeiden, dass beim Zünden der Zündpille Z ein Teil des Stroms z.B. 10 %, auch durch den ohmschen Widerstand R16 fliesst.

Die Darlington Schaltung D mit den Transistoren T7 und T8 gewährleistet eine zuverlässige Zündung der Zündpille Z über die beiden Transistoren T6a und T6b. Die Spannung am Steuereingang 6 darf jedoch nicht kleiner als 2,5 Volt sein. Dank der hohen Stromverstärkung der Darlington-Schaltung D kann der Transistor T6a, T6b auch von einem C-MOS Transistor gesteuert werden.

Wie aus Fig. 2 ersichtlich ist, wird durch die statische Entriegelungsschaltung A die Sperrung durch die statische Sperrschaltung B erst bei einer Spannung U*1 aufgehoben die grösser ist als die Zündspannung UZ und kleiner als die maximale Kondensator Ladespannung UC1.

Somit gilt :

$$UZ \quad U*1 \quad UC1$$

Wie aus Fig. 3 ersichtlich ist, wird die Sperrung bei der Entladung des Zündkondensators C1 erst bei einer Sperrspannung U*2 eingeleitet die kleiner ist als die Zündspannung UZ. Somit gilt :

$$U*2 \quad UZ$$

Dank dieser Bedingung wird verhindert, dass sich der Zündkondensator C1 über den Widerstand R9 und den Transistor T2 entlädt.

Bezugsziffernliste

1) Statische Entriegelungsschaltung A
   T1 Thyristor
   D1 Zenerdiode
   R1, R2, R3 ohmische Widerstände

2) Statische Sperrschaltung B
   T2, T4 Transistoren
   R4, R5, R6, R7, R17 Widerstände

3) Dynamische Sperrschaltung C
   C2 Kondensator
   R10, R11, R12 ohmische Widerstände
   T5, T3 Transistoren

4) Darlington-Schaltung D
   T7, T8 Transistoren
   R8, R13, R14 ohmsche Widerstände

5) Zündpillenschaltung E
   T6a, T6b Transistoren Zündpille
   R15, R16 ohmsche Widerstände
   C1 Kondensator Zündkondensator
   U Batterie Spannungsquelle
   Ri innerer Widerstand

U    Eingangs-Spannung
UE1  Eingangs-Spannung an Spannungsteiler
U*1  Entriegelungsspannung bei Einschaltphase
U*2  Sperrspannung bei Entladephase
UC1  Kondensatorspannung
UZ   Zündspannung
1-6  Klemmen
G1   Entriegelung-Gatter                                    Knotenpunkt für
G2   Sperr-Gatter                                        Transistor T6a und T6b
                                                              Knotenpunkt

D3   Diode

## Patentansprüche

1. Steuerschaltung zum Zünden einer niederohmigen Zündpille (Z) über einen Leistungsschalter (T6a, T6b), mit einer Spannungsquelle (U), wobei
   a) ein von der Spannungsquelle (U) aufladbarer Zündkondensator (C1) angeordnet ist, der mit dem Leistungsschalter (T6a, T6b) und mit der Zündpille (Z) verbunden ist,
   b) eine statische Sperrschaltung (B) angeordnet ist, welche ein Zünden der Zündpille (Z) verhindert, solange der Zündkondensator (C1) aufgeladen wird, mit einem Transistor (T4), der die Basis des Leistungsschalters (T6b) mit Masse verbindet,
   c) eine statische Entriegelungsschaltung (A) angeordnet ist, welche die Sperrung aufhebt, sobald der Zündkondensator (C1) aufgeladen ist, mit einer Zenerdiode (D1) zum Ausschalten der Sperrschaltung (B), sobald die Spannung des Zündkondensators (C1) den Schaltwert der Zenerdiode (D1) erreicht hat,
   d) eine dynamische Sperrschaltung (C) angeordnet ist, welche bei Ausfall des Zündkondensators (C1) ein unbeabsichtigtes Zünden der Zündpille (Z) während des beabsichtigten Ladens des Zündkondensators (C1) verhindert, mit einem Kondensator (C2), der bei steilem Anstieg der Zündspannung eine gewisse Sperrzeit gewährleistet.

2. Steuerschaltung nach Anspruch 1, dadurch gekennzeichnet, dass die statische Entriegelungsschaltung (A) einen Spannungsteiler mit zwei ohmschen Widerständen (R1, R2) zur Erzeugung einer Teilerspannung (UF1) aufweist, sowie eine Zenerdiode (D1), welche einerseits an die Teilerspannung (UF1) und andererseits an die Zündelektrode eines Thyristors (T1) angeschlossen ist, der leitend wird, sobald die Teilerspannung (UF1) den Schaltwert der Zenerdiode (D1) übersteigt.

3. Steuerschaltung nach Anspruch 1 oder 2, dadurch gekennzeichnet, dass die statische Sperrschaltung (B) einen Spannungsteiler mit drei ohmschen Widerständen (R4, R6, R7) zur Erzeugung einer Teilerspannung aufweist, sowie zwei Transistoren (T2 und T4), deren jeweilige Basen an den Spannungsteiler angeschlossen sind.

4. Steuerschaltung nach Anspruch 1, 2 oder 3, dadurch gekennzeichnet, dass die dynamische Sperrschaltung (C) die Serienschaltung des Kondensators (C2) mit einem aus zwei ohmschen Widerständen (R10, R12) bestehenden Spannungsteiler zur Erzeugung einer Teilerspannung aufweist, sowie zwei Transistoren (T3 und T5) deren jeweilige Basen an den Spannungsteiler angeschlossen sind.

5. Steuerschaltung nach einem der vorangehenden Ansprüche, dadurch gekennzeichnet, dass dem Leitungsschalter (T6a, T6b) ein Verstärker in Form einer Darlington-Schaltung (D) vorgeschaltet ist, welche zwei Transistoren (T7 und T8) aufweist, zur Steuerung des Leistungsschalters (T6a, T6b).

6. Steuerschaltung nach dem auf den Anspruch 3 rückbezogenen Anspruch 5, dadurch gekennzeichnet, dass der zweite Transistor (T2) der statischen Sperrschaltung (B) die Basis des Transistors (T7) der Darlington Schaltung (D) mit Masse verbindet.

7. Steuerschaltung nach dem auf den Anspruch 4 rückbezogenen Anspruch 5, dadurch gekennzeichnet, dass der zweite Transistor (T3) der dynamischen Sperrschaltung (C) die Basis des Transistors (T7) der Darlington Schaltung (D) mit Masse verbindet.

## Claims

1. A control circuit for igniting a low-ohm ignition capsule (Z), comprising :
   a) power switch means (T6a, T6b) connected with said lowohm ignition capsule (Z) and with a voltage source (U), an ignition capacitor (C1) connected in circuit with said voltage source (U) and chargeable by means of said voltage source (U), said ignition capacitor (C1) being connected in circuit with said power-switch (T6a, T6b) and with said ignition capsule (Z),
   b) a static blocking circuit (B) for exerting a blocking action, preventing ignition of the ignition capsule (Z) as long as the ignition capacitor (C1) is being charged, said static blocking circuit containing a first transistor (T4) for connecting the base of said power-switch (T6a, T6b) with ground,
   c) a static delatching circuit (A) which eliminates the blocking action of the static blocking circuit (B) as soon as the ignition capacitor (C1) has been charged, said static delatching circuit (A) containing a Zenerdiode (D1) for disconnecting said static blocking circuit (B) as soon as the voltage of the ignition capacitor (C1) has reached a treshold voltage of said Zenerdiode (D1),
   d) a dynamic blocking circuit (C) for preventing an unintentional ignition of said ignition capsule (Z) during the international charging of the ignition capacitor (C1) and said dynamic blocking circuit containing a capacitor (C2) to provide a blocking time if the voltage rises rapidly.

2. The control circuit as defined in claim 1, wherein said static delatching circuit (A) further comprises a voltage divider, containing two ohmic resistors (R1, R2) for generating a divider voltage (UF1) ; said Zener diode (D1) being connected with said voltage divider and with a thyristor (T1) as soon as the voltage of the voltage divider exceeds the treshold value of the Zener diode (D1).

3. The control circuit as defined in claim 1 or 2, wherein said blocking circuit (B) comprises a voltage divider containing three ohmic resistors (R4, R6, R7) for generating a divider voltage and two transistors (T2, T4), each having a base connected with said voltage divider of said static blocking circuit (B).

4. The control circuit as defined in claim 1, 2 or 3 wherein said dynamic blocking circuit (C) further comprises a voltage divider containing said capacitor (C2) and two ohmic resistors (R10, R12) for generating a divider voltage and two transistors (T3, T5) each having a base connected with said voltage divider of said dynamic blocking circuit (C).

5. The control circuit as defined in one of the preceding claims, wherein the power switch (T6a, T6b) is connected with an amplifier containing a Darlington circuit (D) comprising two transistors (T7, T8) for controlling the power switch (T6a, T6b).

6. The control circuit as defined in claim 5 referring to claim 3, wherein a Darlington circuit (D) is operatively connected with said dynamic blocking circuit (C) and said second transistor (T2) of said static blocking circuit (B) connecting a base of a transistor (T7) of the Darlington circuit (D) with ground.

7. The control circuit as defined in claim 5 referring to claim 4, wherein said two transistors (T3, T5) of said dynamic blocking circuit (C) define a first transistor (T5) and a second transistor (T3) and said second transistor (T3) of said dynamic blocking circuit (C) connecting the base of the transistor (T7) of the Darlington circuit (D) with ground.

## Revendications

1. Circuit de commande pour allumer un élément d'allumage faiblement ohmique (Z) par l'intermédiaire d'un commutateur de puissance (T6a, T6b) à l'aide d'une source de tension (U), dans lequel :
   a) il est prévu un condensateur d'allumage (C1) susceptible d'être chargé par la source de tension (U) et qui est relié au commutateur de puissance (T6a, T6b) et à l'élément d'allumage (Z),
   b) un circuit de blocage statique (B) qui interdit l'allumage de l'élément d'allumage (Z) aussi longtemps que se charge le condensateur d'allumage (C1), avec un transistor (T4) qui relie la base du commutateur de puissance (T6b) à la masse,
   c) un circuit de déverrouillage statique (A) qui supprime le blocage dès que le condensateur d'allumage (C1) est chargé, avec une diode Zener (D1) pour couper le circuit de blocage (B) dès que la tension du condensateur d'allumage (C1) atteint la valeur de commutation de la diode Zener (D1),
   d) un circuit de blocage dynamique (C) qui lors de la défaillance du condensateur d'allumage (C1) interdit un allumage accidentel de l'élément d'allumage Z pendant l'opération de charge prévu du condensateur d'allumage (C1) avec un condensateur (C2) qui assure un certain temps de blocage lors d'une montée rapide de la tension d'allumage.

2. Circuit de commande selon la revendication 1, caractérisé en ce que le circuit de déverrouillage statique (A) comporte un diviseur de tension à deux résistances ohmiques (R1, R2) pour former une tension de diviseur (UF1) ainsi qu'une diode Zener (D1) qui est relié d'une part à la tension de diviseur (UF1) et d'autre part à l'électrode d'allumage d'un thyristor (T1) qui devient un conducteur dès que la tension de diviseur (UF1) dépasse la valeur de commutation de la diode Zener (D1).

3. Circuit de commande selon la revendication 1 ou 2, caractérisé en ce que le circuit de blocage statique (B) comprend un diviseur de tension à trois résistances ohmiques (R4, R6, R7) pour générer une tension de diviseur ainsi que de deux transistors (T2 et T4) dont les bases respectives sont reliées au diviseur de tension.

4. Circuit de commande selon la revendication 1, 2 ou 3, caractérisé en ce que le circuit de blocage dynamique (C) se compose d'un montage en série formé du condensateur (C2) et de l'une des deux résistances ohmiques (R10, R12) formant le diviseur de tension pour générer une tension divisée ainsi que deux transistors (T3 et T5) dont les bases respectives sont reliées au diviseur de tension.

5. Circuit de commande selon l'une des revendications précédentes caractérisé en ce que le commutateur de puissance (T6a, T6b) est précédé par un amplificateur sous la forme d'un montage Darlington (D) à deux transistors (T7 et T8) pour la commande du commutateur de puissance (T6a, T6b).

6. Circuit de commande selon la revendication 5 reliée à la revendication 3, caractérisé en ce que le second transistor (T2) du circuit de blocage statique (B) relie la base du transistor (T7) du montage Darlington (D) à la masse.

7. Circuit de commande selon la revendication 5 reliée à la revendication 4, caractérisé en ce que le second transistor (T3) du circuit de blocage dynamique (C) relie la base du transistor (T7) du montage Darlington (D) à la masse.

FIG. 1

FIG. 2

FIG. 3